# EUROPEAN PATENT APPLICATION

(11) **EP 3 444 853 A2**
(43) Date of publication of application: **20.02.2019**
(21) Application number: 18188656.5
(22) Date of filing: 13.08.2018
(51) Int. Cl.: H01L 31/18, H01L 31/05, H01L 31/0747

(54) **METHOD AND DEVICE FOR SOLDERING HETERO-JUNCTION WITH INTRINSIC THIN-FILM SOLAR CELLS TOGETHER TO FORM STRING**

(30) Priority: 16.08.2017 CN 201710701691
(71) Applicant: Beijing Juntai Innovation Technology Co., Ltd, 100176 Beijing (CN)
(72) Inventor: Qi, GUO, Beijing, 100176 (CN); Dezheng, HU, Beijing, 100176 (CN); Jinyan, ZHANG, Beijing, 100176 (CN); Xixiang, XU, Beijing, 100176 (CN); Yuanmin, LI, Beijing, 100176 (CN)
(74) Representative: Nony

(57) **Abstract**

A method for soldering hetero-junction with intrinsic thin-film solar cells together to form a string, includes soldering solar cells, and judging whether a temperature in a soldering chamber is within a preset temperature range every preset time; if the temperature is within the preset temperature range, continuing to solder; and if the temperature is beyond the preset temperature range, regulating the temperature in the soldering chamber to be within the preset temperature range, and continuing to solder the solar cells.

## Description

### TECHNICAL FIELD

The present disclosure relates to the technical field of solar cells, and for example, relates to a method and device for soldering hetero-junction with intrinsic thin-film solar cells together to form a string.

### BACKGROUND

High efficiency and low cost are decisive factors of survival and development of a photovoltaic technology. In a high-efficiency crystalline silicon solar cell technology of mass production, with respect to a hetero-junction solar energy technology with an intrinsic thin-film, that is, SHJ (Silicon-Thin-Film Hetero-Junction) (also called HIT, Hetero-junction with intrinsic thin-film) or HJT (Hetero-Junction), due to advantages of low temperature preparation, simple process steps, good temperature coefficient and the like, the technology is expected to become one of the mainstream technologies in photovoltaic industry. Temperatures in multiple film-preparation processes of SHJ solar cells are 250°C or below. In order to maintain electrical properties of the solar cells and avoid damaging the films, a preparation temperature of each of assemblies prepared subsequently after preparing the films should not exceed 230°C in a certain period of time.

Soldering of the solar cells is generally realized by a full-automatic soldering machine, while the full-automatic soldering machine has many soldering methods. However, most of heating of an automatic soldering machine for crystalline silicon is completed by adopting an solder surface light source for infrared solder, while only a small amount of heating is completed by using electromagnetic induction soldering. Since the electromagnetic induction soldering has a high split rate, a heating part of the vast majority of automatic soldering machines adopts infrared lamp soldering. In an infrared soldering process, in order to increase capacity, a soldering lamp will realize transient heating and heat releasing, heating speed and cooling speed are high, and a temperature change range is wider. The crystalline silicon has a larger temperature control window; control of the temperature to change in a narrow range is difficult to be realized during the infrared soldering process; requirements for the control range and precision are not high; an SHJ chip film will be damaged when the temperature is increased to a higher value; and pseudo soldering will occur when the temperature is decreased to a lower value. Thus, the soldering machines in relevant arts cannot be directly applied onto SHJ chips.

### SUMMARY

The present disclosure provides a method and a device for soldering hetero-junction with intrinsic thin-film solar cells together to form a string. A temperature may be decreased to be within a process-required range allowed by solar cells in a soldering process of SHJ solar cells. Meanwhile, temperature variation is decreased, and soldering reliability is ensured, thereby realizing full-automatic soldering for high-speed mass production of the SHJ solar cells.

An embodiment provides a method for soldering hetero-junction with intrinsic thin-film solar cells together to form a string, including: soldering solar cells, and judging whether a temperature in a soldering chamber is within a preset temperature range every preset time; if the temperature is within the preset temperature range, continuing to solder; and if the temperature is beyond the preset temperature range, regulating the temperature in the soldering chamber to be within the preset temperature range, and continuing to solder the solar cells.

In an embodiment, before soldering solar cells, the method further includes placing the solar cells on a transmission mechanism; and controlling the transmission mechanism to transmit the solar cells into the soldering chamber.

In an embodiment, after the soldering is completed, the method further includes transmitting the solar cells out of the soldering chamber.

In an embodiment, after placing the solar cells on the transmission mechanism, and before controlling the transmission mechanism to transmit the solar cells into the soldering chamber, the method further includes controlling the transmission mechanism to transmit the solar cells into a preheating region, so as to preheat a front side of the solar cells.

In an embodiment, before controlling the transmission mechanism to transmit the solar cells into the preheating region, the method further includes: regulating a distance between a preheating apparatus in the preheating region and the transmission mechanism.

In an embodiment, controlling the transmission mechanism to transmit the solar cells into the soldering chamber includes: controlling the transmission mechanism to transmit the solar cells to a position facing to a light-emitting side of the heating portion in the soldering chamber; and regulating a temperature of the heating portion to be a preset soldering temperature.

In an embodiment, regulating the temperature of the heating portion to be the preset soldering temperature, includes: transmitting a solar-cell-in-position signal to the heating portion when detecting that the solar cells are transmitted into the soldering chamber; and automatically regulating the temperature of the heating portion to the preset soldering temperature according to the solar-cell-in-position signal.

In an embodiment, regulating the temperature in the soldering chamber to be in the preset temperature range includes: monitoring the temperature in the soldering chamber, generating a temperature signal, and transmitting the temperature signal to the heating portion by a temperature monitoring apparatus; and regulating, by the heating portion, the temperature in the soldering chamber to be in the preset temperature range according to the temperature signal.

In an embodiment, the method further includes heating the solar cells at a constant temperature by a heating apparatus disposed on the transmission mechanism in the transmission process.

Another embodiment provides a device for soldering hetero-junction with intrinsic thin-film solar cells together to form a string, includes a transmission mechanism, configured to transmit the solar cells; a soldering chamber, a gap is maintained between a bottom of the soldering chamber and the transmission mechanism; a heating portion, which is arranged in the soldering chamber and is configured to heat the solar cells; thermal insulation structures, which are fixed to the soldering chamber, protruding out of a bottom of the soldering chamber, symmetrically arranged on two sides of the transmission mechanism, and extending to a position below the transmission mechanism; and a temperature monitoring apparatus fixed in the soldering chamber.

In an embodiment, the device further includes a preheating apparatus movable in a vertical direction; the preheating apparatus is arranged on a side, which faces away from a transmission direction of the transmission mechanism, of the soldering chamber; and a size of the preheating apparatus in the transmission direction of the transmission mechanism is larger than a size of the soldering chamber in the transmission direction of the transmission mechanism.

In an embodiment, the device further includes a lamp holder fixed in the soldering chamber; the heating portion includes an infrared heating lamp fixed on the lamp holder; and a detection apparatus, arranged on the soldering chamber and configured to detect a transmission position of the solar cells; and the temperature monitoring apparatus includes a plurality of temperature measuring probes; the temperature measuring probes are fixed at positions, which are away from the infrared heating lamp, of the lamp holder; the solar cells has a plurality of temperature measuring points; and each of the temperature measuring probes is opposed to a respective one of the temperature measuring points.

In an embodiment, a heating apparatus, arranged on the transmission mechanism and configured to provide the constant temperature for the solar cells; and a positioning apparatus, disposed on the transmission mechanism, the solar cells are fixed on the positioning apparatus.

An embodiment provides a low-temperature method for soldering hetero-junction with intrinsic thin-film solar cells together to form a string, including the following steps: placing solar cells on a transmission mechanism; controlling the transmission mechanism to transmit the solar cells into a soldering chamber; soldering the solar cells, and judging whether a temperature in the soldering chamber is in a preset temperature range; if yes, continuing to solder; if not, regulating the temperature in the soldering chamber to be in the preset temperature range, continuing to solder the solar cells, and judging whether the temperature in the soldering chamber is in the preset temperature range; and transmitting the solar cells out of the soldering chamber when soldering is completed.

In an embodiment, controlling the transmission mechanism to transmit the solar cells into the soldering chamber includes: controlling the transmission mechanism to transmit the solar cells to a position opposed to a heating portion in the soldering chamber; regulating a temperature of the heating portion to a preset soldering temperature; and monitoring a temperature in the soldering chamber, and transmitting a temperature signal to the heating portion.

In an embodiment, the solar cells are heated at constant temperature by a heating apparatus on the transmission mechanism in the transmission process.

The present embodiment further provides a low-temperature device for soldering hetero-junction with intrinsic thin-film solar cells together to form a string. The low-temperature method for the hetero-junction with intrinsic thin-film solar cell provided by the present disclosure is adopted, and the low-temperature soldering device for soldering hetero-junction with intrinsic thin-film solar cells together to form a string includes: a transmission mechanism; a soldering chamber, an infrared heating lamp is arranged in the soldering chamber, a distance is maintained between the bottom of the soldering chamber and the transmission mechanism, and thermal insulation structures are fixed to the soldering chamber, protrude out of the bottom of the soldering chamber and are symmetrically arranged on two sides of the transmission mechanism; and a temperature monitoring apparatus, the temperature monitoring apparatus is fixed in the soldering chamber.

In an embodiment, a plurality of temperature measuring probes are arranged in the soldering chamber, a plurality of temperature measuring points are formed in the solar cells, and each of the temperature measuring probes respectively faces to one temperature measuring point.

A lamp holder is fixed in the soldering chamber, and an infrared heating lamp is fixed on the lamp holder.

The temperature measuring probes are fixed at positions, which are far away from the infrared heating lamp, of the lamp holder.

A detection apparatus configured to detect the cell transmission positions is arranged in the soldering chamber.

In an embodiment, a heating apparatus configured to provide a constant temperature for the solar cells is arranged on the transmission mechanism; and a positioning structure is also formed on the transmission mechanism, and the solar cells are fixed on the positioning structure.

In the method and device for soldering hetero-junction with intrinsic thin-film solar cells together to form a string provided by the present disclosure, a temperature of the solar cells in the soldering process is controlled, so that the solar cells can be soldered in the preset temperature range, thereby solving problems in a related art that the soldering machine is great in heating temperature variation and low in temperature control precision, ensuring soldering reliability of the solar cells and realizing the high-speed mass production full-automatic soldering of the SHJ solar cells.

### BRIEF DESCRIPTION OF DRAWINGS

FIG. 1 is a flow chart illustrating a method for soldering hetero-junction with intrinsic thin-film solar cells together to form a string provided in an embodiment;
FIG. 2 is a flow chart illustrating a method for soldering hetero-junction with intrinsic thin-film solar cells together to form a string provided in another embodiment;
FIG. 3 is a front view illustrating a stringing device for soldering hetero-junction with intrinsic thin-film solar cells together to form a string provided in another embodiment; and
FIG. 4 is a side view illustrating a stringing device for soldering hetero-junction with intrinsic thin-film solar cells together to form a string provided in another embodiment.

### List of reference numerals

100-soldering chamber 110-thermal insulation structure
200-infrared heating lamp 300-transmission mechanism
400-temperature monitoring apparatus 500-preheating apparatus
600-heating apparatus 700-positioning apparatus

### DETAILED DESCRIPTION

Embodiments of the present application are described below in detail. Examples of embodiments are illustrated in drawings. The same or similar numerals always represent the same or similar elements or elements with the same or similar functions. Embodiments described below by referring to drawings are illustrative, and are only used for explaining the present application.

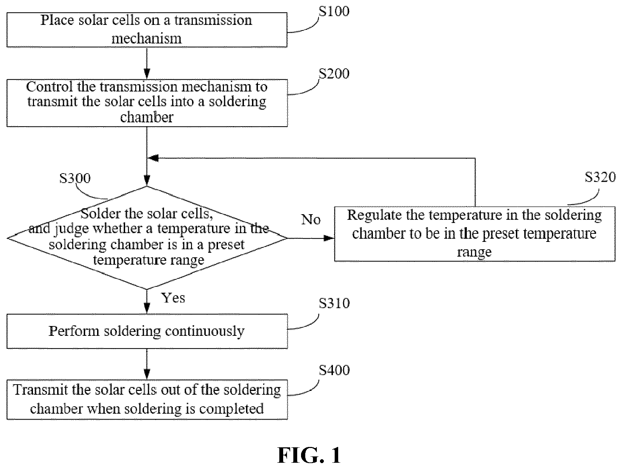

As shown in FIG. 1, the present embodiment provides a method for soldering hetero-junction with intrinsic thin-film solar cells together to form a string, including steps S100-S400.

In S100, solar cells are placed on a transmission mechanism.

In S200, the transmission mechanism is controlled to transmit the solar cells into a soldering chamber.

In S300, the solar cells are soldered, and whether a temperature in the soldering chamber is in a preset temperature range is judged.

In the above steps, whether the temperature in the soldering chamber is in the preset temperature range is judged every preset time until soldering is completed, the preset time may be an interval of milliseconds, which may be regarded as continuous testing;

If the temperature in the soldering chamber is in the preset temperature range, S310 is executed. In S310, soldering is continuously performed.

If the temperature in the soldering chamber is not in the preset temperature range, S310 is executed. In S320, the temperature in the soldering chamber is regulated to be in the preset temperature range, and the step S300 is executed again.

In S400, the solar cells are transmitted out of the soldering chamber when soldering is completed.

In an embodiment, the transmission mechanism can be controlled to transmit the solar cells into the soldering chamber in the cell soldering process. Meanwhile, whether the temperature in the soldering chamber is in the preset temperature range is monitored by the temperature monitoring apparatus in the soldering process; if yes, the soldering operation is continuously performed; if not, the temperature in the soldering chamber is regulated to be in the preset temperature range in time, and whether the temperature in the soldering chamber is in the preset temperature range is monitored again until the soldering operation is completed. That is to say, the temperature monitoring apparatus continuously judges the temperature in the soldering chamber in the whole soldering process, and the temperature can be automatically regulated in time while exceeding the preset temperature range, thereby realizing continuous soldering of the solar cells in the preset temperature range. The preset temperature range may be less than 200°C.

In the method for soldering hetero-junction with intrinsic thin-film solar cells together to form a string provided by the present embodiment, a temperature of the solar cells in the soldering process is controlled, so that the SHJ solar cells can be soldered in the preset temperature range, thereby solving the problems in the related art that the soldering machine is great in heating temperature variation and low in temperature control precision, ensuring soldering reliability of the SHJ solar cells and realizing a full-automatic soldering for the high-speed mass production of the SHJ solar cells.

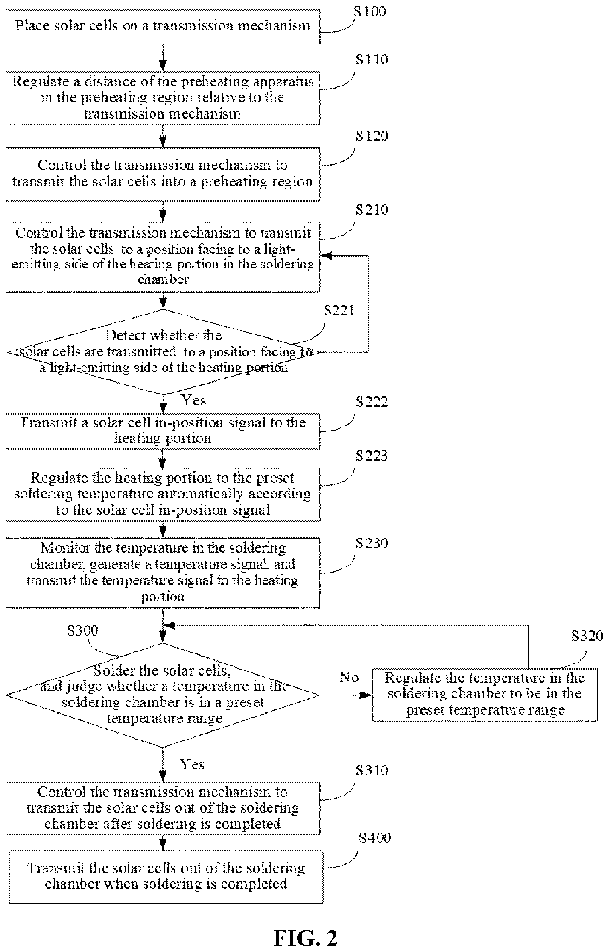

In an embodiment, as shown in FIG. 2, after a step of placing the solar cells on the transmission mechanism, the method further includes S120.

In S120, the transmission mechanism is controlled to transmit the solar cells into a preheating region so as to preheat a front side of the solar cells, so that temperatures of the solar cells and soldering strips are increased to be at a preset height or to be in a preset height range before soldering. Therefore, great temperature variation of the heating portion in the soldering chamber is avoided, and the temperature of the heating portion may rapidly reach a temperature needed by soldering, thereby realizing rapid soldering and increasing soldering efficiency. In the embodiment, the preset region is a region opposed to the preheating apparatus on the transmission mechanism.

Before controlling the transmission mechanism to transmit the solar cells into the preheating region, the method may further include S110.

In S110, a distance between the preheating apparatus in the preheating region and the transmission mechanism is regulated, so as to ensure an appropriate preheating distance maintained between the preheating apparatus and the solar cells, avoid ablation of the solar cells caused by too short distance or avoid that a preheating effect cannot be achieved due to a too long distance.

In an embodiment, controlling the transmission mechanism to transmit the solar cells into the soldering chamber includes: S210-S230.

In S210, the transmission mechanism is controlled to transmit the solar cells to a position facing to a light-emitting side of the heating portion in the soldering chamber, that is, a position facing to the heating portion.

In S220, the temperature of the heating portion is regulated to be a preset soldering temperature.

In S230, the temperature in the soldering chamber is monitored, a temperature signal is generated, and the temperature signal is transmitted to the heating portion. Thus, the temperature signal can be analyzed by the heating portion, and whether the temperature is in the preset temperature range is further judged.

In an embodiment, regulating the temperature of the heating portion to be the preset soldering temperature includes steps S221-S223.

In S221, whether the solar cells are transmitted to a position facing to a light-emitting side of the heating portion in the soldering chamber or not is detected.

If the solar cells are not transmitted to a position facing to a light-emitting side of the heating portion in the soldering chamber, the S210 is executed again.

If the solar cells are transmitted to a position facing to a light-emitting side of the heating portion in the soldering chamber, S222 is executed. In S222, a solar-cell-in-position signal is transmitted to the heating portion.

In S223, the heating portion is automatically regulated to the preset soldering temperature according to the solar-cell-in-position signal. By detecting the cell transmission positions, automatic control on operation and stop of the transmission mechanism is realized, full-automatic control on soldering of the solar cells is further realized, and positioning accuracy and soldering accuracy of the solar cells are improved.

In an embodiment, in order to enable the solar cells to be kept at a constant process temperature in the transmission process, in soldering, and subsequent processing art, and prevent great temperature variation during a process treatment, the solar cells can be heated at a constant temperature by the heating apparatus in the transmission mechanism in the transmission process. The heating apparatus may be connected into an independent control device, so that the temperature of the transmission mechanism can be independently controlled, and different heating requirements for the solar cells are met.

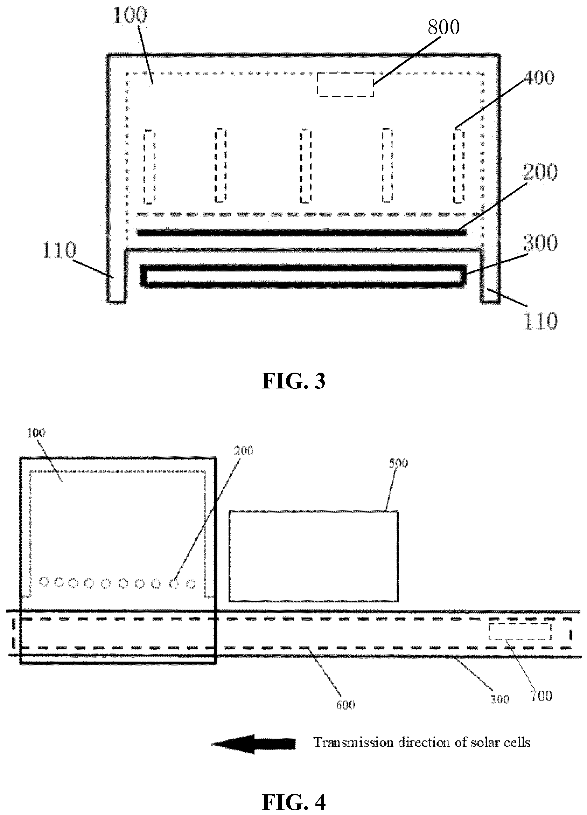

The present embodiment further provides a device for soldering hetero-junction with intrinsic thin-film solar cells together to form a string. The method for the hetero-junction with intrinsic thin-film solar cell provided by any of embodiments is adopted. The device for soldering hetero-junction with intrinsic thin-film solar cells together to form a string includes a transmission mechanism 300, a soldering chamber 100 and a temperature monitoring apparatus 400, an infrared heating lamp 200 configured to heat the solar cells is disposed in the soldering chamber 100; a gap is maintained between a bottom of the soldering chamber 100 and the transmission mechanism 300; and thermal insulation structures 110 are fixed to the soldering chamber 100. With reference to FIG. 3 and FIG. 4, the thermal insulation structures 110 protrude out of the bottom of the soldering chamber 100, are symmetrically arranged on two sides of the transmission mechanism 300 and extend to a position below the transmission mechanism 300; the temperature monitoring apparatus 400 may be, for example, a temperature monitoring probe which is fixed in the soldering chamber 100. Through arrangement of the thermal insulation structures 110, a thermal insulation region is formed between the thermal insulation structures 110 and the soldering chamber 100, so that heat in the soldering chamber 100 can be prevented from being rapidly released, and great temperature variation of the solar cells in the soldering process is further avoided, thereby ensuring the soldering quality of the solar cells. Meanwhile, through the arrangement of the thermal insulation region, heat loss in the thermal insulation region is slower, temperature variation in the thermal insulation region is smaller, and power cost is decreased. In addition, the temperature monitoring apparatus 400 can ensure that the solar cells are soldered in the preset temperature range, thereby avoiding damaging solar cell films due to too great temperature variation in the soldering chamber 100.

In an embodiment, the device for hetero-junction with intrinsic thin-film solar cells together to form a string further includes a preheating apparatus movable in a vertical direction. The preheating apparatus is arranged on a side, which faces away from a transmission direction of the transmission mechanism 300, of the soldering chamber 100, so that the solar cells can be preheated before soldering, the temperature of the solar cells is increased to a preset height before soldering, great temperature variation of the infrared heating lamp 200 in the soldering chamber 100 is avoided, and the temperature of the infrared heating lamp 200 can rapidly reach a temperature needed by the soldering, thereby realizing rapid soldering and increasing soldering efficiency.

Since the preheating apparatus can move in the vertical direction, a distance between the preheating apparatus and the solar cells may be regulated, thereby avoiding ablation of the solar cells caused by too short distance or avoid that a preheating effect cannot be achieved due to too long distance.

A size of the preheating apparatus in the operating direction of the transmission mechanism 300 is larger than a size of the soldering chamber 100 in the operating direction of the transmission mechanism 300, so that time of preheating the solar cells by the preheating apparatus may be prolonged in the transmission process of the solar cells, and the solar cells are fully preheated.

In an embodiment, a detection apparatus 800 configured to detect solar cell transmission positions is fixed in the soldering chamber 100. The detection apparatus 800 can transmit a solar-cell-in-position signal to a controller of the infrared head lamp 200 when it is detected that the solar cells are transmitted to a set position in the soldering chamber 100, and the infrared head lamp 200 is automatically controlled to heat and solder the solar cells according to the solar-cell-in-position signal, thereby realizing automatic control of the soldering of the solar cells and increasing soldering accuracy of the solar cells. Meanwhile, the detection apparatus may also transmit the solar-cell-in-position signal to the controller of the transmission mechanism 300, so as to control operation and stop of the transmission mechanism 300, thereby realizing automatic control of transmission of the solar cells and improving the positioning accuracy of the solar cells.

In an embodiment, a plurality of temperature measuring probes are arranged in the soldering chamber 100; the solar cells have a plurality of temperature measuring points; and each of the temperature measuring probes is opposed to a respective one of the temperature measuring points, so that the temperature variation in the solar cells can be monitored in real time, thereby solving problems that temperature is too high or too low or heating is non-uniform and further ensuring the soldering reliability. In an embodiment, one temperature measuring point may be set in each of fingers of the solar cells, and the rest temperature measuring points are uniformly distributed on a body of the solar cells. In the present embodiment, nine or more temperature measuring points are uniformly set on the solar cells, five temperature measuring points are uniformly distributed on the body of the solar cells, and the additional multiple temperature measuring points are respectively set in the fingers of the solar cells in a one-to-one correspondence manner.

In an embodiment, in order to ensure fixing reliability of the infrared heating lamp 200, a lamp holder may be fixed in the soldering chamber 100, and the infrared heating lamp 200 is fixed on the lamp holder.

The temperature measuring probes may be fixed at positions, which are far away from the infrared heating lamp 200, of the lamp holder, so as to prevent the temperature measuring probes from being interfered by the temperature of the infrared heating lamp 200.

In an embodiment, in order to enable the solar cells to be kept at a constant process temperature in the transmission process and in the soldering or subsequent processing technology, and prevent great temperature variation during process treatment, a heating apparatus configured to provide the constant temperature for the solar cells is arranged on the transmission mechanism 300. Thus, the solar cells can be heated at the constant temperature by the heating apparatus on the transmission mechanism 300 in the transmission process. The heating apparatus may be connected into an independent control device, so that the temperature of the transmission mechanism 300 can be independently controlled, and different heating requirements for the solar cells are met.

In an embodiment, a positioning apparatus may be further disposed on the transmission mechanism 300, and the solar cells are disposed on the positioning apparatus, thereby preventing the solar cells from moving in the transmission or soldering process and other process treatment procedures, and ensuring the process treatment quality.

In the method and device for soldering hetero-junction with intrinsic thin-film solar cells together to form a string provided by the present embodiment, the temperature of the solar cells in the soldering process is controlled, so that the solar cells can be soldered in the preset temperature range, thereby solving the problems in the related art that the soldering machine is great in heating temperature variation and low in temperature control precision, ensuring the soldering reliability of the solar cells and realizing the full-automatic soldering for the high-speed mass production of the SHJ solar cells. In addition, through the arrangement of the preheating apparatus, the solar cells are preheated before soldering, and the temperature of the solar cells is increased to the preset height before soldering, so that the great temperature variation of the infrared heating lamp in the soldering chamber is avoided, and the temperature of the infrared heating lamp may rapidly reach the temperature needed by soldering, thereby realizing the rapid soldering and increasing the soldering efficiency. In addition, through the arrangement of the thermal insulation structures, the thermal insulation region is formed between the thermal insulation structures and the soldering chamber, thereby preventing the heat in the soldering chamber from being rapidly released, further preventing the great temperature variation of the solar cells in the soldering process and ensuring the soldering quality of the solar cells. Meanwhile, through the arrangement of the thermal insulation region, the heat loss in the thermal insulation region is slower, the temperature variation in the thermal insulation regions is smaller, and the power cost is decreased.

## Claims

1. A method for soldering hetero-junction with intrinsic thin-film solar cells together to form a string, **characterized by** comprising:
soldering (S300) solar cells, and judging whether a temperature in a soldering chamber (100) is within a preset temperature range every preset time;
if the temperature is within the preset temperature range, continuing to solder (S310); and
if the temperature is beyond the preset temperature range, regulating (S320) the temperature in the soldering chamber (100) to be within the preset temperature range, and continuing to solder the solar cells.

2. The method according to claim 1, before soldering (S300) solar cells, further comprising:
placing (S100) the solar cells on a transmission mechanism (300); and
controlling (S200) the transmission mechanism (300) to transmit the solar cells into the soldering chamber (100).

3. The method for the hetero-junction with intrinsic thin-film solar cell according to claim 1, after the soldering is completed, further comprising:
transmitting (S400) the solar cells out of the soldering chamber (100).

4. The method for the hetero-junction with intrinsic thin-film solar cell according to claim 2, wherein after placing (SI00) the solar cells on the transmission mechanism (300), and before controlling (S200) the transmission mechanism (300) to transmit the solar cells into the soldering chamber (100), the method further comprises:
controlling (S120) the transmission mechanism (300) to transmit the solar cells into a preheating region, so as to preheat a front side of the solar cells.

5. The method for the hetero-junction with intrinsic thin-film solar cell according to claim 4, wherein before controlling (S120) the transmission mechanism (300) to transmit the solar cells into the preheating region, the method further comprises:
regulating (S110) a distance between a preheating apparatus (500) in the preheating region and the transmission mechanism (300).

6. The method for the hetero-junction with intrinsic thin-film solar cell according to any one of claims 2-5, wherein controlling (S200) the transmission mechanism (300) to transmit the solar cells into the soldering chamber (100) comprises:
controlling (S210) the transmission mechanism (300) to transmit the solar cells to a position facing to a light-emitting side of the heating portion in the soldering chamber (100); and
regulating (S320) a temperature of the heating portion to be a preset soldering temperature.

7. The method for the hetero-junction with intrinsic thin-film solar cell according to claim 6, wherein regulating (S320) the temperature of the heating portion to be the preset soldering temperature, comprises:
transmitting (S222) a solar-cell-in-position signal to the heating portion when detecting that the solar cells are transmitted into the soldering chamber (100); and
automatically regulating (S223) the temperature of the heating portion to the preset soldering temperature according to the solar-cell-in-position signal.

8. The method for the hetero-junction with intrinsic thin-film solar cell according to claim 1, wherein regulating (S320) the temperature in the soldering chamber (100) to be in the preset temperature range comprises:
monitoring (S230) the temperature in the soldering chamber (100), generating a temperature signal, and transmitting the temperature signal to the heating portion by a temperature monitoring apparatus (400); and
regulating (S223), by the heating portion, the temperature in the soldering chamber (100) to be in the preset temperature range according to the temperature signal.

9. The method for the hetero-junction with intrinsic thin-film solar cell according to any one of claims 1-8, further comprising: heating the solar cells at a constant temperature by a heating apparatus (600) disposed on the transmission mechanism (300) in the transmission process.

10. A device for soldering hetero-junction with intrinsic thin-film solar cells together to form a string, **characterized by** comprising:
a transmission mechanism (300), configured to transmit the solar cells;
a soldering chamber (100), wherein a gap is maintained between a bottom of the soldering chamber (100) and the transmission mechanism (300);
a heating portion, which is arranged in the soldering chamber (100) and is configured to heat the solar cells;
thermal insulation structures (110), which are fixed to the soldering chamber (100), protruding out of a bottom of the soldering chamber (100), symmetrically arranged on two sides of the transmission mechanism (300), and extending to a position below the transmission mechanism (300); and
a temperature monitoring apparatus (400) fixed in the soldering chamber (100).

11. The device according to claim 10, further comprising: a preheating apparatus (500) movable in a vertical direction; the preheating apparatus (500) is arranged on a side, which faces away from a transmission direction of the transmission mechanism (300), of the soldering chamber (100); and a size of the preheating apparatus (500) in the transmission direction of the transmission mechanism (300) is larger than a size of the soldering chamber (100) in the transmission direction of the transmission mechanism (300).

12. The device according to claim 11, further comprising a lamp holder fixed in the soldering chamber (100);
wherein the heating portion comprises an infrared heating lamp (200) fixed on the lamp holder; and a detection apparatus (800), arranged on the soldering chamber (100) and configured to detect a transmission position of the solar cells; and
the temperature monitoring apparatus (400) comprises a plurality of temperature measuring probes; the temperature measuring probes are fixed at positions, which are away from the infrared heating lamp (200), of the lamp holder; the solar cells has a plurality of temperature measuring points; and each of the temperature measuring probes is opposed to a respective one of the temperature measuring points.

13. The device according to any one of claims 10-12, further comprising:
a heating apparatus (600), arranged on the transmission mechanism (300) and configured to provide the constant temperature for the solar cells; and
a positioning apparatus (700), disposed on the transmission mechanism (300), wherein the solar cells are fixed on the positioning apparatus (700).
